(19) Europäisches Patentamt
European Patent Office
Office européen des brevets

(11) **EP 4 560 329 B1**

(12) **EUROPEAN PATENT SPECIFICATION**

(45) Date of publication and mention
of the grant of the patent:
**08.07.2026 Bulletin 2026/28**

(51) International Patent Classification (IPC):
***G01R 31/34*** *(2020.01)*

(21) Application number: **23307009.3**

(52) Cooperative Patent Classification (CPC):
**G01R 31/343**

(22) Date of filing: **21.11.2023**

(54) **SYSTEM MONITORING METHOD AND APPARATUS IN A MULTICARRIER SYSTEM, MULTICARRIER SYSTEM**

SYSTEMÜBERWACHUNGSVERFAHREN UND -VORRICHTUNG IN EINEM MEHRTRÄGERSYSTEM, MEHRTRÄGERSYSTEM

PROCÉDÉ ET APPAREIL DE SURVEILLANCE DE SYSTÈME DANS UN SYSTÈME MULTIPORTEUSE, SYSTÈME MULTIPORTEUSE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**28.05.2025 Bulletin 2025/22**

(73) Proprietor: **SCHNEIDER ELECTRIC INDUSTRIES SAS**
**92500 Rueil-Malmaison (FR)**

(72) Inventors:
• **Han, Zhaoqiang**
**77933 Lahr (DE)**
• **Wurth, Rüdiger**
**77654 Offenburg (DE)**

(74) Representative: **Manitz Finsterwald**
**Patent- und Rechtsanwaltspartnerschaft mbB**
**Martin-Greif-Straße 1**
**80336 München (DE)**

(56) References cited:
**EP-A1- 3 958 450     EP-B1- 3 196 719**
**EP-B1- 3 807 605     WO-A1-2012/107431**
**US-B1- 10 432 117**

## Description

The invention relates to a system monitoring method and apparatus in a multicarrier system, and to a multicarrier system.

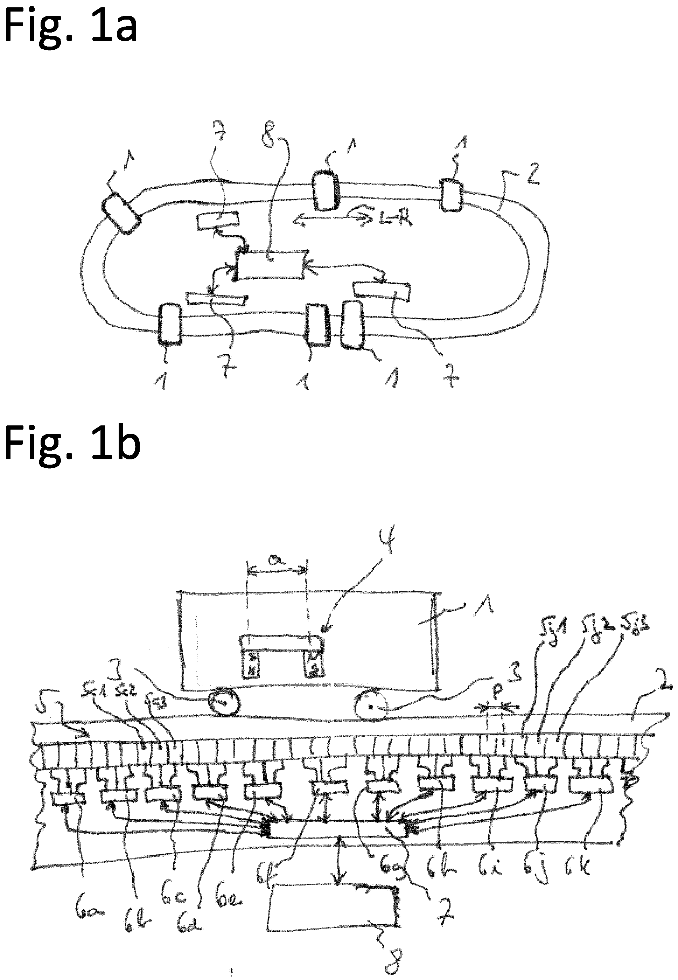

Figs. 1a and 1b show schematically a multicarrier system, in which the invention can be used. The general configuration is shown in Fig. 1a. The system comprises a rail 2 along which one or more carriers 1 can move. The rail 2 is elongated and may have a length of, e.g., more than 1 or 2 or 5 or 10 meters. The rail may have straight and/or curved portions. It may be open or a closed loop as shown in Fig. 1a. As a field of use, one can, again by way of example, assume a manufacturing site in which carriers pass by, traveling along the rail 2, various processing stations for performing certain steps.

The carriers are individually drivable regarding their position, speed and acceleration. Preferably they may move in both directions along the rail, as indicated by the arrow L/R in Fig. 1a.

Driving is made electromagnetically. Each carrier 1 comprises a magnetic installation which may be passive and may, for example, comprise a horseshoe magnet with its two ends of opposing plurality pointing towards the rail and distant from each other along rail direction. Fig. 1b shows this schematically as numeral 4.

The rail 2 comprises, arranged along its length, a plurality of drive elements 5 which may comprise electromagnets. Each of them is individually drivable at least by switching current supply on and off, possibly also with selecting the polarity and strength. The drive elements 5 may be arranged under a regular pitch p along the rail 2. For example, a rail may comprise more than 20 or 30 or 40 drive elements 5 per meter rail length. This leads to a pitch p smaller than 5 or 3,33 or 2,5 cm. The distance a of the horseshoe magnet pole ends in the carrier 1 may be set in relation to said pitch. It may be different from an integer multiple of that pitch.

Accordingly, a high number of drive elements 5 requires control, and for rendering it, a hierarchical control structure may be provided. It may comprise for each drive element 5 a coil controller with a switch 22 and a current sensor 23. Coil group controllers 21 may be provided, each connected to plural coil controllers for feeding them with individual power supply control signals and for receiving from them current measurement signals. A coil group controller 21 may form a unit 6 together with the controlled coil controllers 6.

The overall current control may be provided by pulse width modulation with suitable pulse frequency and a selectable duty ratio, set according to certain target values to be met. One or more segment controllers 7 may be provided, each connected to plural coil group controllers 21. The segment controllers may send current target values to the connected coil group controllers 21 and may collect from the coil group controllers 21 current measurement information.

A system controller 8 may be provided and may be connected to one or more segment controllers 7. It may send control target values such as target position, target speed or target acceleration for each of the plural carriers 1 to the segment controllers. It collects from them the current measurement information. Besides, carrier tracking is performed for the overall system to know where along the system rail 2 the individual carriers 1 are.

Such systems may heavily be used and may experience mechanical impact from the carriers 1 when being accelerated or decelerated or when taking curves. The mechanical impact and other factors may lead to system failures. System failures may be broken power supply lines between drive element 5 and coil controller, particularly switch 22. It may also comprise current sensor malfunction. There is an interest to detect such system failures early and preferably proactively, rather than having to conclude from carrier control difficulties that such failures may exist. Short circuits are further possible failures.

US 10432117 B1 discloses a mover status monitoring method and system in which current and voltage sensors are used for monitoring electric quantities in driving coils.

EP 3 196 719 B1 discloses linear motor system in which coil drive amplifiers monitor their current and voltage output and provide such information to a processor.

EP 3 807 605 B1 and EP 3 958 450 A1 disclose load identification methods of a transport element in a linear motor system in which excitation currents and voltages are detected and used for load and bearing wear estimation.

WO 2012/107431 A1 discloses a carrier system in which for monitoring purposes actual drive current patterns are compared with target current patterns.

It is the object of the invention to provide a system monitoring method and apparatus having an improved detection of failures.

The above object is accomplished by the features of the independent claims.

A system monitoring method has the features of claim 1. A system monitoring method acts in a multicarrier system with a rail along which plural individually drivable electric drive elements are disposed, and one or more carriers drivable along said rail in one or both rail directions. The system monitoring method comprises testwise simultaneously driving plural of said drive elements such that their driving forces exerted on the carrier counteract each other, observing an electric quantity during said driving, preferably a current, at one or more or all of said drive elements, evaluating the observed electric quantity and drawing a conclusion on drive element operation and/or sensor operation based on said evaluation.

When plural drive elements are simultaneously driven such that their driving forces exerted on the carrier counteract each other, the driving forces are altogether reduced and possibly completely cancelled so that their driving impact on the carriers is reduced or practically non-existent.

The simultaneous driving of said plurality of drive elements is preferably made when all carriers do not move. This may be a system state explicitly set for monitoring, or may be a state occurring anyway, for example before regular operation begins at system startup. When said simultaneous driving is made during system standstill, it does not superimpose on other system activities and is not disturbed by them. Besides, if motion or carrier displacement is detected nevertheless, this can be attributed to said testwise simultaneous driving and can further be evaluated.

Accordingly, also a dynamics quantity of at least one carrier taken along said rail may be observed while driving said drive elements. Then, the observed electric quantity and the observed dynamics quantity may be jointly evaluated. Conclusions may be drawn on drive element operation and/or sensor operation based on said joint evaluation. The dynamics quantity may be a speed value or a displacement value of a carrier taken along said rail.

As said earlier, multicarrier systems have carrier tracking installations for tracking the position as one dynamics quantity, and possibly other dynamics quantities such as speed and acceleration, of each carrier in real time. Tracking may be made for each carrier and may be or include position and/or speed detection of the individual carriers. It may, e.g., involve the use of detection signals from pass-by detectors provided along the rail, possibly in conjunction with some or all drive elements, interpolating detected positions based on a known carrier speed profile and time lapse, evaluating electromagnetic reaction of the drive elements 5 on the presence of a carrier 1, and possibly other techniques. It may be of an accuracy of a carrier position along said rail of better than the pitch of the drive elements 5 or better than 2 or 1 cm or 2 or 1 mm. The carrier speed v may computationally be obtained as a derivative of carrier location with respect to time.

If during or after said testwise simultaneous driving the mentioned dynamics quantities alter different from what is to be expected in response to that testwise simultaneous driving, this is an indication on something being against the assumptions. It may be a faulty power supply to one of the drive elements so that forces exerted on the carrier are not as balanced as assumed, or it may be a tracking error. And vice versa, if dynamics are as expected, but the observation of the electric quantity suggests a fault, this may be an indication for an error in the current detection. Altogether, and more generally, dynamics quantity detection may be used for cross-checking with electric quantity detection for a more detailed system analysis.

Testwise simultaneously driving the plural drive elements may be made such that the resulting force exerted by the driven drive elements on a carrier in rail direction is less than an absolute or relative threshold. The absolute threshold may be a force value of 0,2 or 0,1 or 0,05 or 0,02 N. The relative threshold may be 10 or 5 or 2 or 1 or 0.5% of the overall sum of amounts of all forces exerted on said carrier or may be 2 or 1 or 0,5 or 0.2 % of the weight force of an unloaded carrier 1.

It is preferred that the forces acting on a carrier during the simultaneous testwise driving are small and, best case, completely cancel out each other. Numerically, this can be expressed at the resultant forces in rail direction at the carrier being less than a fraction of the sum of amounts of all forces.

The driving of a drive element may be or comprise the generation or supply or reception or setting of a current target value or of a driving pulse signal for said drive element or may be or comprise switching on and off the electric power supply to a drive element and may be made with the use of a PWM apparatus component.

Accordingly, the testwise simultaneous driving may relate to any one of a plural activities in a PWM structure from target value setting to switching. Vice versa, testwise simultaneous driving needs not be the strictly simultaneous switching of switches or the like.

The multicarrier system may be designed such that the resulting force in rail direction exerted by all drive elements of said system on a carrier, if driven simultaneously, is irrespective of the carrier position along the rail less than an absolute or relative threshold. The absolute threshold may be a force value of 0,2 or 0,1 or 0,05 or 0,02 N. The relative threshold may be 10 or 5 or 2 or 1 or 0.5% of the overall sum of amounts of all forces exerted on said carrier or may be 2 or 1 or 0,5 or 0.2 % of the weight force of an unloaded carrier 1. The simultaneous driving involves then the simultaneous driving of all drive elements of said system.

Actually, it is an inherent property of many multicarrier systems that when all drive elements are driven simultaneously in same polarity and same quantity, a carrier "sees" a magnet field profile along the rail that is more or less homogeneous without a gradient in the one or the other rail direction so that although magnetic forces are present from all drive elements, they practically cancel out and thus do not move a carrier. In these systems, the testwise simultaneous driving may be such that all drive elements of the system are simultaneously driven in same polarity and same strength. Again, this may be made in terms of PWM quantities and may, for example, be the simultaneous provision of a same current target value to all control structures of all drive elements.

Observing the electric quantity may be or comprises the observation of plural individual quantities of the corresponding plural individual drive elements. Observing said plural quantities may be made simultaneously or in time series or group-wise simultaneously. The observation of an electric quantity may be a check whether an instantaneous current value exceeds a threshold, preferably in a defined observation time window, or may be the measurement of an average value, and its comparison with a threshold.

Preferably, electrical quantities such as currents are obtained for every single drive element. If hardware allows it, they are preferably obtained at the same time. This may include that information is obtained in identifiable and allocatable manner, meaning that an observation information is allocated or allocatable to a certain drive element.

In many embodiments, the precise current value may be of no interest. Then, observing may be the check whether a current value, such as an instantaneous current value, or a related value exceeds a suitably defined threshold or not, and the observation result is simply a "yes" or "no" in combination with an identifier of the drive element to which this observation relates. Instead of instantaneous current values, also other current values may be monitored and possibly threshold-compared, such as average current values during the testwise simultaneous driving after a steady state current has established. Threshold check and averaging may be made on the analog side with OpAmps and possibly low passes. But it may also be made on the digital side after A/D conversion of instantaneous values. The observation result relating to an individual drive element may finally be present in a digital format, said digital format including an identifier of the respective drive element.

Instead of the testwise simultaneous driving of all drive elements, the method may comprise a step of selecting plural drive elements for driving them for monitoring purposes, selecting them such that the resulting force in rail direction exerted by the selected drive elements, when driven simultaneously, on a carrier is, in consideration of the carrier position along the rail, less than an absolute or relative threshold. The absolute threshold may be a force value of 0,2 or 0,1 or 0,05 or 0,02 N. The relative threshold may be 10 or 5 or 2 or 1 or 0.5% of the overall sum of amounts of all forces exerted on said carrier, or may be 2 or 1 or 0,5 or 0.2 % of the weight force of an unloaded carrier 1. Such a selection may be made computationally and may include the setting of individual current target values $Id^*_i$ for the plural drive elements 5 with different indices i. The selection can be made with reference to the known relative position of the respective carriers 1 relative to all of the drive elements 5. The simultaneous driving may then include that different drive elements receive different drive signals with the intention of generating counteracting forces along rail direction and balancing their sum along rail direction below a mentioned threshold.

A system monitoring apparatus defined in claim 9 acts in a multicarrier system that has a rail along which plural individually drivable electric drive elements are disposed, and at least one carrier drivable by said drive elements along said rail in one or both rail directions. The system monitoring apparatus comprises a driving means for simultaneously driving plural of said drive elements such that their driving forces on the carrier counteract each other, observing means for observing, while driving said drive elements, an electric quantity, preferably a voltage or a current, at one or more or all of said drive elements, and evaluation means for evaluating the observed electric quantity and for drawing a conclusion on drive element operation and/or sensor operation based on said evaluation. Said driving means may be configured to drive all drive elements of said system simultaneously or a suitable, force-balanced selection therefrom.

As a practical implementation, the monitoring apparatus may be implemented jointly with the overall control structure of the multicarrier system. Assuming that significant parts of the control structure are computer implemented, this may as well apply for the monitoring apparatus components. They may utilize the regular driving hardware for the drive elements, particularly a possibly provided PWM structure. The monitoring activities may then be a special operation mode of the overall control structure in which the provided hardware is used differently from the regular drive mode. Modifications for rendering the monitoring apparatus may be predominantly on the digital and software-implemented side of the control structure and may invoke the calling of particular monitoring routines that are then run instead of the usual use routines.

The apparatus may also comprise means for observing a dynamics quantity, preferably position or speed, of one or more or all carriers along said rail. The evaluation means are then configured to jointly evaluate the electric quantity and the dynamics quantity.

The dynamics quantity observation may utilize the regular carrier tracking structure of the overall control. It may be configured to check whether a carrier has moved or not during said testwise simultaneous driving. It may be a query whether or not a carrier has moved and/or gained speed, and the answer to said query may be utilized for evaluation.

In the following, features of the invention are explained with the reference to the accompanying drawings.

Fig. 1a is a schematic multicarrier system representation,
Fig. 1b is a detailed view of a carrier 1 on a rail piece 2,
Fig. 2a is a detailed representation of drive elements and parts of control structures,
Fig. 2b shows a possible signal flow in the control structure,
Fig. 3a shows the magnetically relevant installations in carrier and rail,
Fig. 3b shows a resultant magnetic field that a carrier may experience,
Fig. 3c shows field properties,
Fig. 4a is a representation of an example of a test current target value over time,
Fig. 4b is a representation of PWM voltage pulses, a current and thresholds, and

Fig. 5 shows an overall method for system monitoring.

Figs. 1a and 1b have already been explained to some extent.

Fig. 1b schematically shows a carrier 1 on a part of a rail 2. It may have some kind of wheels 3 with which it can roll along the rail 2, which is left-right in Fig. 1b.

Driving the carrier 1 along rail 2 may be possible in one rail direction, such as the left direction in Fig. 1b, or may be possible in both directions, i.e. left-right and right-left in Fig. 1b.

For the rail 2, a row of drive elements 5 is schematically shown. The row has said drive elements 5 more or less juxtaposed and aligned along the rail direction.

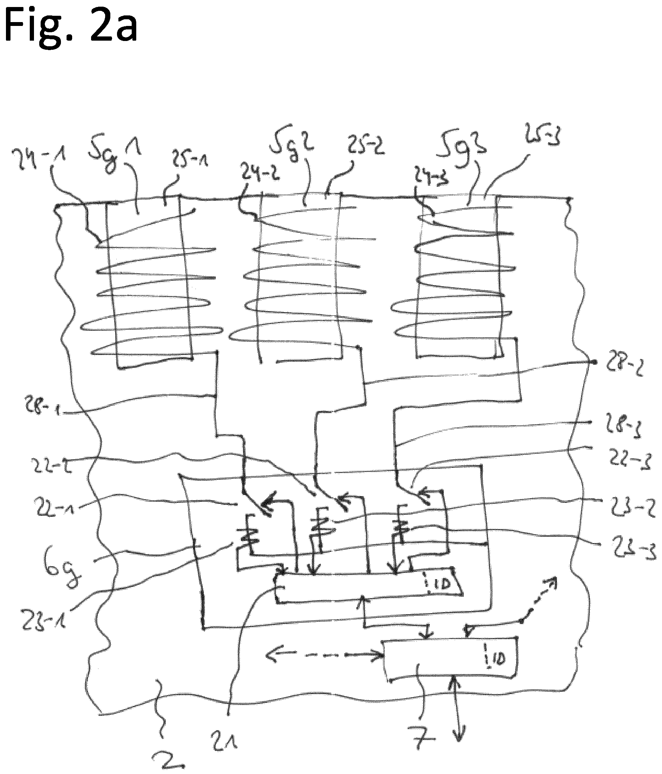

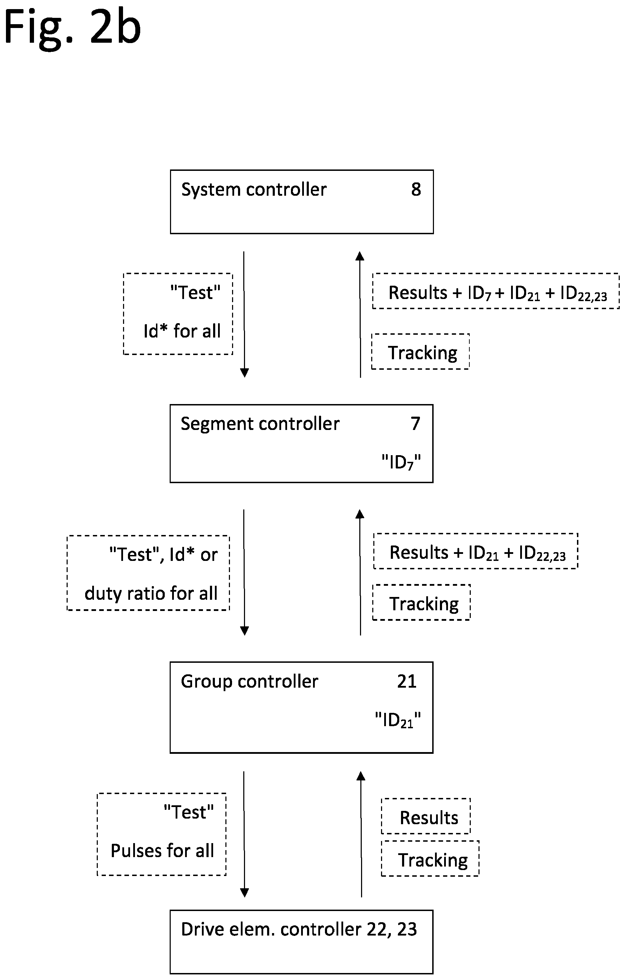

As said already earlier, more than 20 or 30 or 40 drive elements 5 per meter rail length may be provided, giving a drive element pitch p of less than 5 or 3.33 or 2.5 cm. Each of the drive elements 5 has an own controllable power supply. Also, polarity of power supply may be controllable. Fig. 2 shows this more in detail. It is assumed that a group of some drive elements 5 may be driven by a coil group controller 21. In a practical implementation, the number of drive elements of one such group is 3. But it may likewise be 2 or 4 or 5 or 6 or more. The coil controllers for each coil comprise a switch 22 for switching the electromagnet coil of the respective drive element 5. The switch may be a semiconductor switch, such as a FET, an IGBT or the like. The switch is connected to the respective coil 24 of the respective electromagnet via wiring 28. The coil 24 is wound around a magnetic core 25. Figs. 1 and 2 show, for the sake of clearness, only the one switched wiring and omits the other as well as a common power source etc.

Likewise, each coil controller may comprise a measurement sensor for measuring the respective coil current. The measurement sensor may be an inductive tap or may comprise a small dimensioned measurement resistor, such as a shunt, producing a certain voltage drop when passed by current. Fig. 2 shows for one group of drive elements 5g1, 5g2 and 5g3 a control block 6g comprising the coil group controller 21 for said group and the coil controllers for the electromagnets of this group, particularly the switches 22-1, 22-2 and 22-3 to the respective electromagnets 24-1, 24-2 and 24-3, wound around cores 25-1, 25-2 and 25-3, and connected by wirings 28-1, 28-2 and 28-3. Current sensors are shown with 23-1, 23-2 and 23-3.

The coil group controller 21 outputs control signals towards the respective switches 21 and receives input from the respective current sensors 23. The coil group controller 21 may be or comprise digital components and may comprise suitable D/A and A/D conversion elements at the interface towards the coil controllers. As far as required, coil group controller 21 may have suitable multiplexing capabilities for handling on the output side and/or on the input side the signals to and from or for the various coil controllers.

Besides, the coil group controller may have an ID inscribed, utilized to identify monitoring results that it sends elsewhere. The coil group controller 21 may add to said ID an identification of the individual drive element 5 from which the respective result was obtained. The coil group controller 21 may also have said ID optically readably attached, e.g. as bar code or QR code or alphanumeric, so that for maintenance it can easily be identified.

The drive elements 5 comprise each an electromagnet 24, 25 comprising a respective core 25 around which a respective coil 24 is wound. It thus constitutes an elongated electromagnet with its lengthwise direction pointing from the rail 2 upward towards the carrier 1. Plural electromagnets 24, 25 of plural drive elements 5 may be arranged in close juxtaposition to each other along the rail direction, as shown in Fig. 1b and enlarged in Fig. 2a. If polarity of power supply is not controllable, the arrangement may be such that upon energization, all electromagnets 24, 25 show the same polarity towards the rail, e.g. a north pole.

The coil group controllers 21 may be provided close to the respectively controlled drive elements 5. The distance may be shorter than 20 or 10 cm to each of the connected drive elements 5. The coil group controller 21 may be provided as a unit 6 together with the switches and measurement installations for the respective drive element. But likewise, switch 22 and measurement installation, such as a current sensor 23, may be built separate therefrom and may be built as a unit with a respective drive element 5.

Fig. 2a shows also a segment controller 7 connected to said coil group controller 21. It is also connected to other coil group controllers 21 functionally left and right along the rail of the shown coil group controller 21. The number of coil group controllers 21 connected to segment controller 7 may be 2 or 3 or more than 3 or more than 5 or more than 10. It may be less than 50 or less than 20. Segment controller 7 may be a digital structure with digital communication capabilities towards coil group controller 21 and towards a system controller 8. Segment controller 7 may again have an ID inscribed for distinguishing it from other segment controllers 7. A segment controlled by a segment controller 7 may be a physically separable unit of the rail 2. Such a segment is physically and logistically connectable to other segments for forming the overall rail. A segment may form a length of rail of, e.g., more than 20 or 50 or 100 cm. It may be shorter than 200 or 150 or 100 cm.

The overall system may comprise plural qualitatively same segment controllers 7 communicating with a system controller 8 as shown in Fig. 1b. The system controller 8 may be a digital component such as a microcomputer. It has knowledge on the system, particularly knowledge on the topography and the control structure. It may also performs carrier tracking of the carriers 1 provided along rail 2. It is capable to send instructions forward and to receive fed-back information, such as observation results. System controller 8 itself may be connectable to other components, possibly through a network. System controller 8 may be connected to 1, 2, 3 or more than 3 or more than 5 or more than 10 segment controllers 7. It may be connected to less than 200 or 150 or 100 or 50 segment controllers 7.

Fig. 2b shows a possibility for the signal flow in the control structure when system monitoring activities are taken. In the described hierarchy, only respectively one of the possibly plural downstream connected components is shown.

Starting monitoring activities may be decided by the system controller, for example periodically or upon operation start of the system or upon user command or the like. Once it is decided to conduct monitoring activities, it may first be established that all carriers rest at speed zero, if this is not the case anyway. Then, a test mode information can be sent from the system controller 8 downstream to the connected segment controllers 7, possibly together with a certain direct current target value Id* for all segment controllers 7.

The segment controllers 7, knowing that a test is to be performed, may forward the current target value Id* to the connected group controllers or may create a suitable duty ratio command in PWM control for meeting the instructed direct current target value Id* and may send this duty ratio command to the connected group controllers, together again with an information that a test is to be performed.

The group controllers 21 may determine a duty ratio if they receive a current target value Id* from a segment controllers 7 and may implement it by generating respective pulse trains for all connected switches 22, or just implement a received duty ratio command by generating respective pulse trains for all connected switches 22 of the connected drive elements 5. The relation between a current target value Id* to a duty ratio may be a fixed characteristics, implemented by a formula to be computed or by a table to be accessed.

The current target value Id* and the resultant duty ratio value are chosen for evoking measurable current values in possibly coarse and/or slow current sensors 23. The values of the current target value Id* and/or the resultant duty ratio may be more than 0,2 or 0,5% of respectively possible maximum values. They may be lower than 20 or 10 or 5 or 2% of said maximum values.

The current target value Id* and/or a corresponding duty ratio for PWM for the testwise simultaneous driving may be fixedly set or inscribed into the system or may variably automatically or manually be set according to necessities. The current developing in the testwise simultaneous driving may be adjusted with feedback control in closed loop control or without feedback control in open loop control. The latter has the advantage of simpleness and that possibly PWM duty ration can be directly set for test purposes without requiring a current target value Id*. The former has the advantage of accuracy because inaccuracies of inductances, resistances, etc. in the system are eliminated by the control loop.

Monitoring of the electrical quantities, particularly currents to the respective electromagnets 24 through the respective wirings 28 may be made in suitable manner by the respective current sensors 23 and communicated to the respective group controller 21. These may be analog signals. In suitable manner, they may be processed in the group controller, e.g. by a threshold comparison and generating a respective check result together with an information on the respective drive element 5 from which said information was obtained. The group controller 21 may assemble such check results from the plural connected drive elements 5 and may feed them back to segment controller 7, together with its own ID ID21 for identifying the source of information. Also, certain tracking information may be forwarded here in conventional manner for allowing carrier tracking, if this is desired during monitoring tests.

Tracking carrier positions may involve, for each carrier, one or more of tracking detection signals from pass-by detectors provided along the rail (e.g. by position magnets attached at the carrier which are detected by hall sensors provided along the rail/track), possibly in conjunction with some or all drive elements, interpolating detected positions based on a known carrier speed profile and time lapse, and evaluating electromagnetic reaction of the drive elements 5 on the presence of a carrier 5.

The segment controller 7 assembles results from the plural connected group controllers 21, may make evaluations, may add its own ID ID7 to the assembled results and generated evaluations, and forwards it, possibly together with carrier tracking information, to the system controller 8. The system controller 8 then has the result from all drive elements 5 in the system, particularly observation results of the electrical quantities at said drive elements, and possibly has also from the conventional tracking information on positions of the carriers 1. These information may then be evaluated in the system controller 8.

It is pointed out that the hierarchy needs not be as shown in Figs. 1 and 2. Two stages thereof may be unified into one apparatus. The communications shown in figure 2b amongst the various components in hierarchically downward and upward direction may follow known protocols that are not described here. They may involve fieldbus protocols and/or network protocols. They may be analog and/or digital..

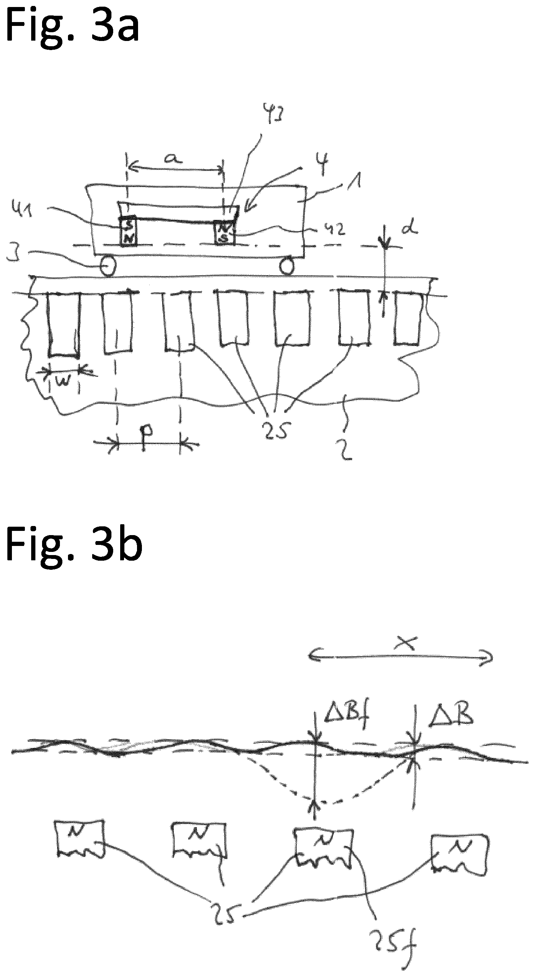

Figs. 3a to 3c show electromagnetic relationships that may be exploited for performing the mentioned monitoring activities. Fig. 3a shows geometries in the rail 2 and in the carrier 1. Plural cores 25 of electromagnets of the drive elements 5 are juxtaposed preferably under a regular pitch p. A carrier 1 itself has magnetic installations 4 therein. It may be passive and may be the already mentioned horseshoe magnet. It may be assembled from individual magnets 41, 42 in opposing orientation, distant from each other along rail direction and connected to a magnetic yoke 43. The magnetic installation 4 in the carrier 1, particularly the lower surfaces of the horseshoe magnet, may have a distance d from the top surfaces of the cores 25 of the electromagnets of the drive elements 5. A horseshoe magnet 4 in the carrier 1 may have an opening a along rail direction of the centers of the magnet poles. The distance a may be different from an integer multiple of pitch p. This has the effect that magnetic characteristics relative to each of the cores 25 would not necessarily add up at carrier 1.

Fig. 3b shows the resulting magnetic field when the electromagnets of the drive elements are all testwise simultaneously driven in the same manner. It is assumed that they receive all the same target value Id* for establishing a respective current through the respective coils 24. Then all electromagnets may, for example, exhibit a north pole towards carrier 1, and carrier 1 experiences a practically homogenous or uniform north pole from the plural electromagnets. The fields from the plural drive elements 5 superimpose such that the ripple ΔB in the magnetic field B experienced by the carrier 1 is relatively low and almost zero, resulting also in a gradient dB/dx of the magnetic field in rail direction being low to practically zero. In terms of forces, the plural magnetic forces exerted from the plural electromagnets on the carrier counteract and add up to low or almost 0 values.

Numerically, said counteracting may be expressed as a sum S(Fi) of all forces Fi in rail direction acting on a carrier. The forces Fi along rail direction are vector quantities with a sign + or -. For not causing carrier movement during the testwise driving, their sum should be low, such as

$$S(Fi) < Fth$$

with Fth being a threshold force such as 0,5 or 0,2 or 0.1 or 0.05 or 0.02 or 0.01 N. Likewise, the ratio r of the sum S(Fi) of all counteracting forces Fi in rail direction acting on a carrier 1 to the sum of the amounts of all forces Fi in rail direction S(|Fi|) may be considered. The amounts |Fi| of forces are stripped of their sign and are all positive. Said ratio r should be low, such as

$$r = S(Fi) / S(|Fi|) < rth$$

with rth being a threshold ratio such as 0.1 or 0.05 or 0.02 or 0.01 or 0.005. Or said counteracting may express the sum S(Fi) of all forces Fi in rail direction as a fraction of the weight force Fc of an unloaded carrier. Said fraction should be low for causing practically no acceleration, such as

$$S(Fi) < f * Fc$$

with f being 0,02 or 0,01 or 0,005 or 0.002.

As far as switching of the various drive elements is not strictly simultaneous, short-time force imbalances may occur. Over time, they average out numerically, and they are of time constants in the range of the PWM switching frequency and thus much shorter than time constants of inert carriers 1 experiencing said imbalances so that they do not cause carrier acceleration.

The overall effect of this is that, as long as the system operates properly, a carrier 1 experiences practically no resulting driving forces along rail direction and the testwise simultaneous driving of all drive elements 5 for monitoring purposes does not alter the positions of the carriers 1 along the rail and thus does not interfere with the regular use, except requiring the time interruption for performing the monitoring activities.

Fig. 3b shows the low magnetic ripple ΔB with the continuous line above the magnet tops. If one of the electromagnets 25 is faulty and does, for example, not receive electric current, it will not generate a magnetic field. If in Fig. 3b, for example, magnet 25f is faulty and does not receive a current, the resulting overall field is less homogeneous and a significantly larger ripple ΔBf would occur. Fig. 3b shows such a resulting magnetic field B with the hatched line. Likely, this would have effect on a nearby carrier in that contrary to the earlier situation it would experience some kind of driving force and would move. Accordingly, such kind of movement during testwise simultaneous driving could indicate some kind of error in the driving of the drive elements 5. Carrier tracking as described earlier would reveal such an error, and can also be used as described further below.

Fig. 3a shows for the cores 25 of the electromagnets a width w in rail direction, a pitch p of the drive elements 5 and a distance d between magnet core faces of the rail 2 and the carrier 1. Constructional features contributing to obtaining the desired homogenous magnetic field along rail direction upon testwise simultaneous driving are that said width w may be more than 20 or 30 or 40 or 50 % of the pitch p amongst the cores 25, and or that the ratio d/p of the distance d to the drive element pitch p may be larger than or 0,005 or 0,01. It may be lower than 0,1 or 0,05.

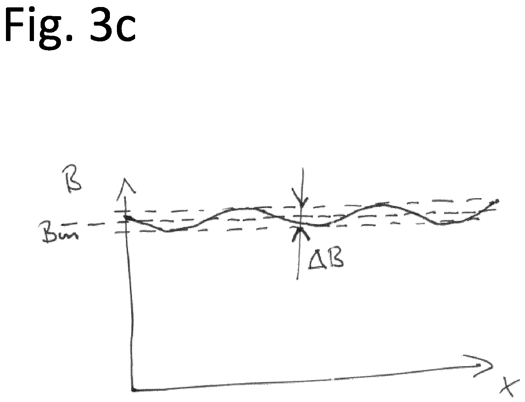

Fig. 3c shows a profile of a magnetic field B along rail direction x. Similar to fig. 3b, it varies with a ripple in a range ΔB around a medium value or average value Bm when the testwise simultaneous driving is made equally for all drive elements 5. The overall design may be such that in correct operation the ratio of ripple range ΔB to medium or average value Bm measured, and thus experienced, at the underside of the carriers is smaller than a variance threshold vth, i.e.

$$ΔB/Bm < vth$$

with vth being smaller than 0,2 or 0,1 or 0,05 or 0,02. This is achieved by the described mechanical design, but may also be achieved by other measures and suits then for carrying out the invention.

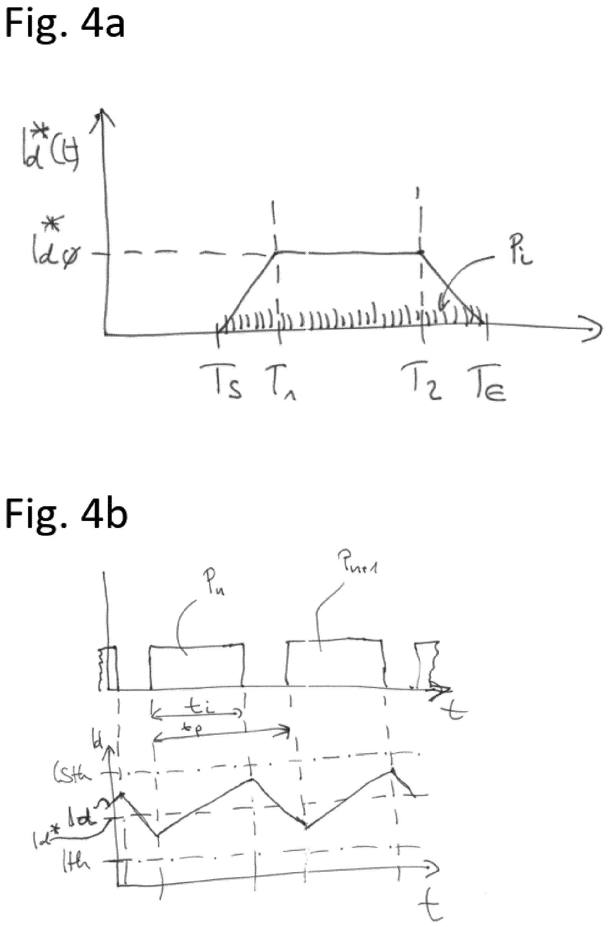

Fig. 4a shows an example of a current target value Id* for the testwise simultaneous driving. The duration of the testwise simultaneous driving may overall be relatively short between a start time Ts and an end time $T_E$ and may last less than 200 or 100 or 50 ms. The current target value Id*(t) may be a constant value $Id^*_0$ between start time Ts and end time $T_E$ or may have an ascending slope between start time Ts and time T1, a descending slope between T2 and end time $T_E$ and said constant value $Id^*_0$ between T1 and T2 as shown in figure 4a. The constant value may be a fraction of the maximum possible system current. It is selected in view of measurement requirements, power supply requirements and the desire to cause minimum impact on the carriers. The same applies for the duration of the testwise driving.

Fig. 4a symbolizes also the individual PWM impulses Pi that may be used for adjusting, as time average, the current target value Id*. As said earlier, driving of the electromagnets may be made with pulse width modulation (PWM) for switching on/off respective control transistors constituting switches 22, this leading to resultant instantaneous and average current and voltage values according to the usual considerations and laws of physics.

Fig. 4b shows in the upper diagram two consecutive pulses Pn and Pn+1 along the time line t and in the lower diagram a resultant current Id. It is given for a case that the L/R time constant of the electromagnet drive system of the drive element 5 with overall effective inductance L and overall effective resistance R (e.g. more than 0,5 or 1 ms, such as 3 ms) is significantly longer than the PWM pulse period duration tp (e.g. less than 200 or 100 $\mu$s, such as 17 $\mu$s). Insofar, $L/R > n * tp$ may apply with n being 10 or 20 or 50 or 100. Then, in ordinary operation, the actual current Id never reaches a constant value. Rather, it undulates around the target value Id*.

According to the current target value Id*, the pulses have a certain duration ti in relation to the pulse period tp, with the ratio ti/tp called duty ratio. The pulse frequency may be more than 1 or 10 or 20 kHz, e.g. 60 kHz. Correspondingly, the pulse period tp is less than 1 ms or 100 $\mu$s or 50 $\mu$s. The pulse duration ti is a fraction thereof according to the duty ratio.

Current evaluation may, in the shown situation, be made with respect to a lower current threshold Ith and/or a higher second current threshold Isth. They may be selected such that in ordinary operation, namely no line brake, no short circuit, the actual current Id undulates between the two thresholds without passing one of them. Vice versa, when one of them is passed, it may be an indication of a malfunction, namely line brake in case the current drops below the lower threshold Ith or short circuit in case the current exceeds the second threshold Isth.

In other than the shown situation, measurement timings and/or threshold checks made for monitoring purposes may be synchronized on the PWM pulses or on the PWM pulse pauses. They may be synchronized on the on-time of the respective current driving for measuring on the rising edge or the off-time of the respective current driving for measuring on the falling edge, if it is in meaningful measurable ranges, which depends on time constants. A measurement time and/or threshold check or current range check may be at or around the middle of each pulse or pulse pause.

The above described current measurements or evaluations and threshold checks may constitute the mentioned observance of an electric quantity for checking whether the wiring towards the respective drive element 5 and possibly more generally its allover driving are correct.

Noise and dynamic effects may lead to temporary or transient untypical values. For reducing their impact, averaging across plural individual measurements or threshold judgements, e.g. at plural pulses Pi, may be made. More than 1 or 2 or 5 measurements/judgements may be averaged. Less than 50 or 20 or 10 may be taken. Averaging or majority voting may be used. This may be made in a respective drive element 5 or in the respective group controllers 21 or in the respective segment controller 7 and may respectively be reported hierarchically upward in figure 2b.

A possibility of evaluating the above described observation of an electric quantity would be to decide on correct connectivity if the measured current or its average or the majority voting meets the expectation, e.g. exceeds the threshold Ith, and to decide on an error otherwise. Such an approach is suitable for many cases. For current evaluation it may also be checked whether a measured current is within an expected range around an expected current Ie, such as Ie plusminus 30 or 20 or 10 or 5% of Ie.

Current measurement may always be made at or around the middle timing of a PWM voltage pulse, such as the pulse middle timing plus minus 10 or 5 or 2% of pulse duration at the rising edge, or at or around the middle timing of the pulse pause between two neighboring PWM voltage pulses, such as the pulse pause middle timing plusminus 10 or 5 or 2% of pulse pause duration at the falling edge. In these cases, the measured current is approximately equal to the averaged current within a PWM pulse or possibly also pulse pause, depending on time constants.

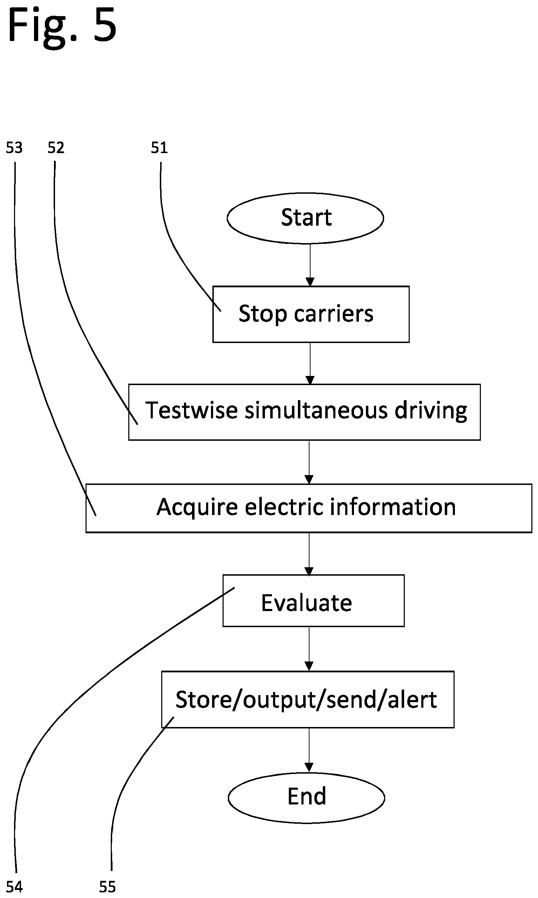

Fig. 5 shows an overall view of the overall monitoring method. Start may be commanded by a user or periodically or, for example, at certain system states such as system start or system shutdown. After start, all carriers 1 may be brought to stand still in step 51, if this is not already given by the system state from which the monitoring starts.

Then, in step 52, the testwise simultaneous driving of all or plural selected drive elements 5 follows. During said driving, in step 53 at least an electric quantity is acquired. It may be the current flowing in coils 24 of electromagnets or the threshold comparison result as explained earlier. Particularly, currents of all simultaneously driven drive elements 5 and coils 24 therein may be acquired. Likewise, dynamics information of carriers 1, e.g. their position, may be acquired in conventional manner.

In step 54, evaluations of the acquired quantities are made. They may be the threshold checks explained earlier.

In step 55, the evaluation result is stored or output or sent through a network somewhere, or an alert is generated and output/sent.

As said earlier, the testwise simultaneous driving in step 52 may be such that all system drive elements 5 are driven simultaneously with same current target values Id*. But instead of simultaneously driving all drive elements 5 of the system, a selection of drive elements 5 to be driven simultaneously may be made. A "balanced selection" may be made such that only selected drive elements 5 are driven, possibly with same or differing current target values Id*, for obtaining, at a respective nearby carrier 1, from said selected drive elements 5 the counteracting and practically cancelling forces as described above. The subsequent steps would then be performed for the selected drive elements 5. The selection would be made prior to step 52 and may be made computationally in consideration of the known position of a carrier. It may include the setting of individual current target values $Id*_i$ for the selected drive elements for obtaining the desired quantitative counteracting results.

Features described in this specification and/or in the claims and/or shown in a figure shall be deemed combinable with and amongst each other also if their combination is not expressly described, to the extent that the combination is technically feasible. Features described in a certain context, embodiment, figure or claim shall be deemed separable from this claim, context, embodiment or figure and shall be deemed combinable with every other figure, claim, context or embodiment, to the extent that it is technically feasible. Embodiments and figures shall not be understood as being meant necessarily exclusive against each other. Features described as part of an embodiment or a figure shall be deemed separable from this embodiment or figure and shall be deemed combinable with features of other embodiments or figures, as far as technically possible. Descriptions of a method or procedure or a method step or a procedural step shall be understood also as a description of means for implementing the method or procedure or method step or procedural step and/or shall possibly also be understood as a description of an artefact made or modified by said method or procedure or method step or procedural step and/or shall possibly also be understood as a description of a data carrier holding program instructions of executable code adapted for implementing the method or procedure or method step or procedural step, and vice versa. In the present specification, references to the "invention" address the teaching as subjectively conceived by the inventors.

List of reference numerals:

| 1 | carrier |
| 2 | rail |
| 3 | wheel |
| 4 | magnetic installation |
| 5 | drive element |
| 6 | group controller |
| 7 | segment controller |
| 8 | system controller |
| 21 | group controller |
| 22 | switch |
| 23 | current sensor |
| 24 | coil |
| 25 | core |
| 28 | wiring |
| 41, 42 | permanent magnets |
| 43 | yoke |
| 51 - 55 | method steps |

**Claims**

1. System monitoring method in a multicarrier system, the multicarrier system comprising a rail (2) along which plural individually drivable electric drive elements (5) are disposed, and at least one carrier (1) drivable by said drive elements (5) along said rail (2) preferably in any of the two rail directions, **characterized in that** the system monitoring method comprises

   (a) simultaneously driving plural or all of said drive elements (5) such that their driving forces exerted on the carrier (1) counteract each other,
   (b) while simultaneously driving said drive elements (5), observing an electric quantity, preferably a current, at one or more or all of said drive elements (5) with one or more current sensors (23), and
   (c) evaluating the observed electric quantities and drawing a conclusion on drive element operation and/or sensor operation based on said evaluation.

2. The method of claim 1, wherein driving the plural drive elements (5) is made such that the resulting force in rail direction exerted by the driven drive elements (5) on a carrier (1) is less than an absolute or relative threshold, an absolute threshold being a value of 0,2 or 0,1 or 0,05 or 0,02 N, and a relative threshold being 10 or 5 or 2 or 1 or 0.5% of the overall sum of amounts of all forces exerted on said carrier or being 2 or 1 or 0,5 or 0.2 % of the weight force of an unloaded carrier (1).

3. The method of claim 1 or 2, wherein driving an electric drive element comprises switching on and off the power supply to an electromagnet and may be made with the use of a PWM apparatus.

4. The method of one of the preceding claims, used in a PWM controlled system where the L/R time constant of the driven drive elements (5) satisfies L/R > n * tp where tp is the PWM pulse period duration and n is 5 or 10 or 20 or 50 or 100, wherein observing an electric quantity comprises one or more threshold checks of the current (Id) flowing in a drive element (5).

5. The method of claim 4, wherein said threshold checks include that in ordinary operation, namely checking whether the current (Id) drops below a lower threshold (Ith) and/or checking whether said current exceeds a second higher threshold (Isth).

6. The method of one of the preceding claims, used in a multicarrier system designed such that the resulting force in rail direction exerted by all drive elements of said system on a carrier, if driven simultaneously, is irrespective of its position along the rail less than an absolute or relative threshold, an absolute threshold being a value of 0,2 or 0,1 or 0,05 or 0,02 N, and a relative threshold being 10 or 5 or 2 or 1 or 0.5% of the overall sum of amounts of all forces exerted on said carrier or being 2 or 1 or 0,5 or 0.2 % of the weight force of an unloaded carrier (1).

7. The method of one of the preceding claims, wherein observing the electric quantity comprises the observation of plural individual quantities of the corresponding plural individual drive elements, wherein observing said plural quantities may be made simultaneously or in time series or group-wise simultaneously, wherein the observation of an electric quantity may be a check whether an instantaneous current value exceeds a threshold, preferably in a defined observation time window, or may be the measurement of an average value.

8. The method of one of the claims 1 to 3, comprising selecting the plural driven drive elements (5) from all drive elements (5) of the system such that the resulting force in rail direction exerted by the selected drive elements, when driven simultaneously, on a particular carrier (1) is, in consideration of its position along the rail, less than an absolute or relative threshold, an absolute threshold being a value of 0,2 or 0,1 or 0,05 or 0,02 N, and a relative threshold being 10 or 5 or 2 or 1 or 0.5% of the overall sum of amounts of all forces exerted on said carrier or being 2 or 1 or 0,5 or 0.2 % of the weight force of an unloaded carrier (1).

9. System monitoring apparatus for a multicarrier system, the multicarrier system comprising a rail (2) along which plural individually drivable electric drive elements (5) are disposed, and at least one carrier (1) drivable by said drive elements (5) along said rail (2) preferably in any of the two rail directions,

the system monitoring apparatus, preferably adapted to carry out the method according to one of the preceding claims, wherein the system monitoring apparatus comprises driving means (6, 7, 8) for simultaneously driving plural of said drive elements,
**characterized in that**
the driving means are configured to simultaneously drive plural of said drive elements (5) such that their driving forces on the carrier (1) counteract each other,
observing means (23) are provided for observing, while simultaneously driving said drive elements (5), an electric quantity, preferably a voltage or a current, at one or more or all of said drive elements with one or more sensors, and evaluation means (21) are provided for evaluating the observed electric quantity and for drawing a conclusion on drive element operation and/or sensor operation based on said evaluation.

10. The apparatus of claim 9, used in a multicarrier system designed such that the resulting force in rail direction exerted by all drive elements (5) of said system on a carrier, if driven simultaneously, is irrespective of its position less than an absolute or relative threshold, an absolute threshold being a value of 0,2 or 0,1 or 0,05 or 0,02 N, and a relative threshold being 10 or 5 or 2 or 1 or 0.5% of the overall sum of amounts of all forces exerted on said carrier or being 2 or 1 or 0,5 or 0.2 % of the weight force of an unloaded carrier 1, and said driving means (6, 7, 8) are configured to drive all drive elements (5) of said system simultaneously.

11. The apparatus of claims 9 or 10, adapted to be used in a PWM controlled system where the L/R time constant of the driven drive elements (5) satisfies L/R > n * tp where tp is the PWM pulse period duration and n is 5 or 10 or 20 or 50 or 100, wherein the observing means comprise one or more threshold check means for the current (Id) flowing in a drive element (5).

12. The apparatus of one of the claims 9 to 11, integrated into a control system of the multi carrier system.

13. The apparatus of one of the claims 9 to 12, wherein the ratio d/p of the distance d between magnet surfaces of the rail (2) and magnet surfaces of the carrier (1) to the drive element pitch p may be larger than 0,005 or 0,01 and may be lower than 0,05 or 0,02 or 0,011, and/or the ratio w/p of the width w of the electromagnet cores (24) facing the carrier (1) to the drive element pitch p is larger than 0,2 or 0,4.

14. A multicarrier system comprising

a rail (2) along which plural individually drivable electric drive elements (5) are disposed,

at least one carrier (1) drivable by said drive elements (5) along said rail (2) preferably in any of the two rail directions,

a control structure (22, 23, 21, 7, 8) for driving said carrier (1) along said rail (2),

tracking means for tracking the position of the driven carrier (1) in said multicarrier system, and

a system monitoring apparatus of one of the claims 9 to 13.

15. The multicarrier system of claim 14, wherein the control structure is hierarchically structured and comprises

plural coil controllers (22, 23), each connected to a respective drive element (5) for feeding it with power, preferably PWM power, and generating current measurement signals,

plural coil group controllers (6, 21), each connected to plural coil controllers (22, 23) for feeding them with power supply control signals, preferably PWM control signals, and for receiving from them current measurement signals, one or more segment controllers (7), each connected to plural coil group controllers (21) for sending them current target values and for collecting from them current measurement information, and

a system controller (8) connected to one or more segment controllers (7) for sending them carrier target speed values ort target position values, for collecting from them current measurement information and for carrier tracking.

**Patentansprüche**

1. Verfahren zur Systemüberwachung in einem Mehrträgersystem, wobei das Mehrträgersystem eine Schiene (2), entlang der mehrere einzeln antreibbare elektrische Antriebselemente (5) angeordnet sind, sowie mindestens einen Träger (1) umfasst, der durch die Antriebselemente (5) entlang der Schiene (2) vorzugsweise in jeder der beiden Schienenrichtungen antreibbar ist, **dadurch gekennzeichnet, dass** das Verfahren zur Systemüberwachung umfasst

(a) das gleichzeitige Antreiben mehrerer oder aller der Antriebselemente (5) derart, dass sich ihre auf den Träger (1) ausgeübten Antriebskräfte einander entgegenwirken,

(b) während des gleichzeitigen Antriebs der Antriebselemente (5) das Beobachten einer elektrischen Größe, vorzugsweise eines Stroms, an einem oder mehreren oder allen der Antriebselemente (5) mit einem oder mehreren Stromsensoren (23), und

(c) Auswerten der beobachteten elektrischen Größen und Ziehen eines Rückschlusses hinsichtlich des Betriebs der Antriebselemente und/oder des Betriebs der Sensoren auf der Grundlage dieser Auswertung.

2. Verfahren nach Anspruch 1, wobei das Antreiben der mehreren Antriebselemente (5) so erfolgt, dass die resultierende Kraft in Schienenrichtung, die von den angetriebenen Antriebselementen (5) auf einen Träger (1) ausgeübt wird, kleiner ist als ein absoluter oder relativer Schwellenwert, wobei ein absoluter Schwellenwert ein Wert von 0,2 oder 0,1 oder 0,05 oder 0,02 N ist, und ein relativer Schwellenwert 10 oder 5 oder 2 oder 1 oder 0,5 % der Gesamtsumme der Beträge aller auf den Träger ausgeübten Kräfte oder 2 oder 1 oder 0,5 oder 0,2 % der Gewichtskraft eines unbeladenen Trägers (1) beträgt.

3. Verfahren nach Anspruch 1 oder 2, wobei das Antreiben eines elektrischen Antriebselements das Ein- und Ausschalten der Stromversorgung eines Elektromagneten umfasst und unter Verwendung einer PWM-Vorrichtung erfolgen kann.

4. Verfahren nach einem der vorhergehenden Ansprüche, das in einem PWMgesteuerten System verwendet wird, wobei die $L/R$-Zeitkonstante der angetriebenen Antriebselemente (5) die Bedingung $L/R > n *$ tp erfüllt, wobei tp die Dauer der PWM-Impulsperiode und n 5 oder 10 oder 20 oder 50 oder 100 ist, wobei das Beobachten einer elektrischen Größe eine oder mehrere Schwellenwertprüfungen des in einem Antriebselement (5) fließenden Stroms (Id) umfasst.

5. Verfahren nach Anspruch 4, wobei die genannten Schwellenwertprüfungen im Normalbetrieb die Prüfung umfassen, ob der Strom (Id) einen unteren Schwellenwert (Ith) unterschreitet und/oder ob der genannte Strom einen zweiten höheren Schwellenwert (Isth) überschreitet.

6. Verfahren nach einem der vorhergehenden Ansprüche, das in einem Mehrträgersystem verwendet wird, das so ausgelegt ist, dass die resultierende Kraft in Schienenrichtung, die von allen Antriebselementen des Systems auf einen Träger ausgeübt wird, wenn diese gleichzeitig angetrieben werden, unabhängig von dessen Position entlang der Schiene kleiner ist als ein absoluter oder relativer Schwellenwert, wobei ein absoluter Schwellenwert einen Wert von 0,2 oder 0,1 oder 0,05 oder 0,02 N hat, und wobei ein relativer Schwellenwert 10 oder 5 oder 2 oder 1 oder 0,5 % der Gesamtsumme der Beträge aller auf den Träger ausgeübten Kräfte oder 2 oder 1 oder 0,5 oder 0,2 % der Gewichtskraft eines unbeladenen Trägers (1) beträgt.

7. Verfahren nach einem der vorhergehenden Ansprüche, wobei das Beobachten der elektrischen Größe das Beobachten mehrerer Einzelgrößen der entsprechenden mehreren einzelnen Antriebselemente umfasst, wobei das Beobachten der mehreren Größen gleichzeitig oder zeitlich nacheinander oder gruppenweise gleichzeitig erfolgen kann, wobei das Beobachten einer elektrischen Größe eine Überprüfung sein kann, ob ein Momentanstromwert einen Schwellenwert überschreitet, vorzugsweise in einem definierten Beobachtungszeitfenster, oder die Messung eines Mittelwerts sein kann.

8. Verfahren nach einem der Ansprüche 1 bis 3, umfassend das Auswählen der mehreren angetriebenen Antriebselemente (5) aus allen Antriebselementen (5) des Systems derart, dass die resultierende Kraft in Schienenrichtung, die von den ausgewählten Antriebselementen bei gleichzeitigem Antreiben auf einen bestimmten Träger (1) unter Berücksichtigung seiner Position entlang der Schiene kleiner ist als ein absoluter oder relativer Schwellenwert, wobei ein absoluter Schwellenwert einen Wert von 0,2 oder 0,1 oder 0,05 oder 0,02 N hat und wobei ein relativer Schwellenwert 10 oder 5 oder 2 oder 1 oder 0,5 % der Gesamtsumme der Beträge aller auf den Träger ausgeübten Kräfte oder 2 oder 1 oder 0,5 oder 0,2 % der Gewichtskraft eines unbeladenen Trägers (1) beträgt.

9. Systemüberwachungsvorrichtung für ein Mehrträgersystem, wobei das Mehrträgersystem eine Schiene (2) umfasst, entlang der mehrere einzeln antreibbare elektrische Antriebselemente (5) angeordnet sind, sowie mindestens einen Träger (1), der durch die Antriebselemente (5) entlang der Schiene (2) vorzugsweise in jeder der beiden Schienenrichtungen antreibbar ist,

wobei die Systemüberwachungsvorrichtung vorzugsweise dazu ausgelegt ist, das Verfahren gemäß einem der vorhergehenden Ansprüche durchzuführen, wobei die Systemüberwachungsvorrichtung Antriebsmittel (6, 7, 8) zum gleichzeitigen Antreiben mehrerer der Antriebselemente umfasst,
**dadurch gekennzeichnet, dass**
die Antriebsmittel so ausgebildet sind, dass sie mehrere der Antriebselemente (5) gleichzeitig so antreiben, dass sich ihre auf den Träger (1) wirkenden Antriebskräfte einander entgegenwirken,
Beobachtungsmittel (23) vorgesehen sind, um während des gleichzeitigen Antriebs der Antriebselemente (5) eine elektrische Größe, vorzugsweise eine Spannung oder einen Strom, an einem oder mehreren oder allen der Antriebselemente mit einem oder mehreren Sensoren zu beobachten, und
Auswertemittel (21) vorgesehen sind, um die beobachtete elektrische Größe auszuwerten und auf der Grundlage dieser Auswertung einen Rückschluss auf den Betrieb der Antriebselemente und/oder den Betrieb der Sensoren zu ziehen.

10. Vorrichtung nach Anspruch 9, die in einem Mehrträgersystem verwendet wird, das so ausgelegt ist, dass die resultierende Kraft in Schienenrichtung, die von allen Antriebselementen (5) des Systems auf einen Träger ausgeübt wird, wenn diese gleichzeitig angetrieben werden, unabhängig von ihrer Position kleiner ist als ein absoluter oder relativer Schwellenwert, wobei ein absoluter Schwellenwert 0,2 oder 0,1 oder 0,05 oder 0,02 N beträgt, wobei ein relativer Schwellenwert 10 oder 5 oder 2 oder 1 oder 0,5 % der Gesamtsumme der Beträge aller auf den Träger ausgeübten Kräfte oder 2 oder 1 oder 0,5 oder 0,2 % der Gewichtskraft eines unbeladenen Trägers 1 beträgt, und wobei die Antriebsmittel (6, 7, 8) so ausgebildet sind, dass sie alle Antriebselemente (5) des Systems gleichzeitig antreiben.

11. Vorrichtung nach Anspruch 9 oder 10, die zur Verwendung in einem PWMgesteuerten System ausgelegt ist, wobei die L/R-Zeitkonstante der angetriebenen Antriebselemente (5) die Bedingung L/R > n * tp erfüllt, wobei tp die Dauer der PWM-Impulsperiode und n 5 oder 10 oder 20 oder 50 oder 100 ist, wobei die Beobachtungsmittel ein oder mehrere Schwellenwertprüfmittel für den in einem Antriebselement (5) fließenden Strom (Id) umfassen.

12. Vorrichtung nach einem der Ansprüche 9 bis 11, integriert in ein Steuersystem des Mehrträgersystems.

13. Vorrichtung nach einem der Ansprüche 9 bis 12, wobei das Verhältnis d/p des Abstands d zwischen den Magnetflächen der Schiene (2) und den Magnetflächen des Trägers (1) zur Antriebselementteilung p größer als 0,005 oder 0,01 sein kann und kleiner als 0,05 oder 0,02 oder 0,011 sein kann, und/oder das Verhältnis w/p der Breite w der dem Träger (1) zugewandten Elektromagnetkerne (24) zur Antriebselementteilung p größer als 0,2 oder 0,4 ist.

14. Mehrträgersystem, umfassend

eine Schiene (2), entlang der mehrere einzeln antreibbare elektrische Antriebselemente (5) angeordnet sind, mindestens einen Träger (1), der durch die Antriebselemente (5) entlang der Schiene (2) vorzugsweise in jeder der beiden Schienenrichtungen antreibbar ist,
eine Steuerstruktur (22, 23, 21, 7, 8) zum Antreiben des Trägers (1) entlang der Schiene (2),
Verfolgungsmittel zum Verfolgen der Position des angetriebenen Trägers (1) in dem Mehrträgersystem, und
eine Systemüberwachungsvorrichtung nach einem der Ansprüche 9 bis 13.

**15.** Mehrträgersystem nach Anspruch 14, wobei die Steuerstruktur hierarchisch aufgebaut ist und umfasst

mehrere Spulensteuerungen (22, 23), die jeweils mit einem entsprechenden Antriebselement (5) verbunden sind, um dieses mit Leistung, vorzugsweise PWM-Leistung, zu speisen und Strommesssignale zu erzeugen,
mehrere Spulengruppensteuerungen (6, 21), die jeweils mit mehreren Spulensteuerungen (22, 23) verbunden sind, um diese mit Stromversorgungssteuersignalen, vorzugsweise PWM-Steuersignalen, zu speisen und von diesen Strommesssignale zu empfangen,
eine oder mehrere Segmentsteuerungen (7), die jeweils mit mehreren Spulengruppensteuerungen (21) verbunden sind, um diesen Stromsollwerte zu senden und von diesen Strommessinformationen zu erfassen, sowie
eine Systemsteuerung (8), die mit einer oder mehreren Segmentsteuerungen (7) verbunden ist, um diesen Trägersollgeschwindigkeitswerte oder Sollpositionswerte zu senden, um von diesen Strommessinformationen zu erfassen und zur Trägerverfolgung.

**Revendications**

**1.** Procédé de surveillance d'un système dans un système à porteuses multiples, le système à porteuses multiples comprenant un rail (2) le long duquel sont disposés plusieurs éléments d'entraînement électriques (5) pouvant être entraînés individuellement, et au moins une porteuse (1) pouvant être entraînée par lesdits éléments d'entraînement (5) le long dudit rail (2), de préférence dans l'une ou l'autre des deux directions du rail,
**caractérisé en ce que** le procédé de surveillance du système comprend

(a) l'entraînement simultané de plusieurs ou de la totalité desdits éléments d'entraînement (5) de telle sorte que leurs forces d'entraînement exercées sur la porteuse (1) s'opposent les unes aux autres,
(b) tout en entraînant simultanément lesdits éléments d'entraînement (5), l'observation d'une grandeur électrique, de préférence un courant, au niveau d'un ou de plusieurs ou de tous lesdits éléments d'entraînement (5) à l'aide d'un ou de plusieurs capteurs de courant (23), et
(c) l'évaluation des grandeurs électriques observées et le fait de tirer une conclusion sur le fonctionnement des éléments d'entraînement et/ou des capteurs sur la base de ladite évaluation.

**2.** Procédé selon la revendication 1, dans lequel l'entraînement des éléments d'entraînement multiples (5) est effectué de telle sorte que la force résultante dans la direction du rail exercée par les éléments d'entraînement entraînés (5) sur une porteuse (1) soit inférieure à un seuil absolu ou relatif, un seuil absolu étant une valeur de 0,2 ou 0,1 ou 0,05 ou 0,02 N, et un seuil relatif étant de 10 %, 5 %, 2 %, 1 % ou 0,5 % de la somme totale des valeurs absolues de toutes les forces exercées sur ladite porteuse, ou étant de 2 %, 1 %, 0,5 % ou 0,2 % de la force de poids d'une porteuse (1) non chargée.

**3.** Procédé selon la revendication 1 ou 2, dans lequel l'entraînement d'un élément d'entraînement électrique comprend la mise sous tension et hors tension de l'alimentation électrique d'un électroaimant et peut être réalisé à l'aide d'un dispositif PWM.

**4.** Procédé selon l'une des revendications précédentes, utilisé dans un système commandé par PWM où la constante de temps L/R des éléments d'entraînement entraînés (5) satisfait L/R > n * tp, où tp est la durée de la période d'impulsion PWM et n est égal à 5, 10, 20, 50 ou 100, dans lequel l'observation d'une grandeur électrique comprend un ou plusieurs contrôles de seuil du courant (Id) circulant dans un élément d'entraînement (5).

**5.** Procédé selon la revendication 4, dans lequel lesdits contrôles de seuil comprennent, en fonctionnement normal, à savoir vérifier si le courant (Id) tombe en dessous d'un seuil inférieur (Ith) et/ou vérifier si ledit courant dépasse un deuxième seuil supérieur (Isth).

**6.** Procédé selon l'une des revendications précédentes, utilisé dans un système à porteuses multiples conçu de telle sorte que la force résultante dans la direction du rail exercée par tous les éléments d'entraînement dudit système sur une porteuse, si ceux-ci sont entraînés simultanément, soit, quelle que soit sa position le long du rail, inférieure à un seuil absolu ou relatif, un seuil absolu étant une valeur de 0,2 ou 0,1 ou 0,05 ou 0,02 N, et un seuil relatif étant de 10, 5, 2, 1 ou 0,5 % de la somme totale des valeurs de toutes les forces exercées sur ladite porteuse, ou étant de 2, 1, 0,5 ou 0,2 % de la force de poids d'une porteuse non chargée (1).

**7.** Procédé selon l'une des revendications précédentes, dans lequel l'observation de la grandeur électrique comprend l'observation de plusieurs grandeurs individuelles des éléments d'entraînement individuels correspondants, dans lequel l'observation desdites plusieurs grandeurs peut être effectuée simultanément ou en séries chronologiques ou par groupes simultanément, dans lequel l'observation d'une grandeur électrique peut consister à vérifier si une valeur de courant instantanée dépasse un seuil, de préférence dans une fenêtre temporelle d'observation définie, ou peut consister en la mesure d'une valeur moyenne.

**8.** Procédé selon l'une des revendications 1 à 3, comprenant la sélection de plusieurs éléments d'entraînement entraînés (5) parmi tous les éléments d'entraînement (5) du système de telle sorte que la force résultante dans la direction du rail exercée par les éléments d'entraînement sélectionnés, lorsqu'ils sont entraînés simultanément, sur une porteuse particulière (1) soit, compte tenu de sa position le long du rail, inférieure à un seuil absolu ou relatif, un seuil absolu étant une valeur de 0,2 ou 0,1 ou 0,05 ou 0,02 N, et un seuil relatif étant de 10 ou 5 ou 2 ou 1 ou 0,5 % de la somme totale des valeurs absolues de toutes les forces exercées sur ladite porteuse ou étant de 2 ou 1 ou 0,5 ou 0,2 % de la force de poids d'une porteuse (1) non chargée.

**9.** Appareil de surveillance de système pour un système à porteuses multiples, le système à porteuses multiples comprenant un rail (2) le long duquel sont disposés plusieurs éléments d'entraînement électriques (5) pouvant être entraînés individuellement, et au moins une porteuse (1) pouvant être entraînée par lesdits éléments d'entraînement (5) le long dudit rail (2), de préférence dans l'une ou l'autre des deux directions du rail,

l'appareil de surveillance du système étant de préférence adapté pour mettre en œuvre le procédé selon l'une des revendications précédentes, dans lequel l'appareil de surveillance du système comprend des moyens d'entraînement (6, 7, 8) pour entraîner simultanément plusieurs desdits éléments d'entraînement,
**caractérisé en ce que**
les moyens d'entraînement sont configurés pour entraîner simultanément plusieurs desdits éléments d'entraînement (5) de telle sorte que leurs forces d'entraînement exercées sur la porteuse (1) s'opposent les unes aux autres,
des moyens d'observation (23) sont prévus pour observer, tout en entraînant simultanément lesdits éléments d'entraînement (5), une grandeur électrique, de préférence une tension ou un courant, au niveau d'un ou de plusieurs ou de tous lesdits éléments d'entraînement à l'aide d'un ou de plusieurs capteurs, et
des moyens d'évaluation (21) sont prévus pour évaluer la grandeur électrique observée et pour tirer une conclusion sur le fonctionnement des éléments d'entraînement et/ou le fonctionnement des capteurs sur la base de ladite évaluation.

**10.** Appareil selon la revendication 9, utilisé dans un système à porteuses multiples conçu de telle sorte que la force résultante dans la direction du rail exercée par tous les éléments d'entraînement (5) dudit système sur une porteuse, s'ils sont entraînés simultanément, soit, quelle que soit sa position, inférieure à un seuil absolu ou relatif, un seuil absolu étant une valeur de 0,2 ou 0,1 ou 0,05 ou 0,02 N, et un seuil relatif étant de 10 ou 5 ou 2 ou 1 ou 0,5 % de la somme totale des valeurs absolues de toutes les forces exercées sur ladite porteuse ou étant de 2 ou 1 ou 0,5 ou 0,2 % de la force de poids d'une porteuse 1 non chargée, et lesdits moyens d'entraînement (6, 7, 8) sont configurés pour entraîner tous les éléments d'entraînement (5) dudit système simultanément.

**11.** Appareil selon les revendications 9 ou 10, adapté pour être utilisé dans un système commandé par PWM où la constante de temps L/R des éléments d'entraînement entraînés (5) satisfait L/R > n * tp, où tp est la durée de la période d'impulsion PWM et n est égal à 5, 10, 20, 50 ou 100, dans lequel les moyens d'observation comprennent un ou plusieurs moyens de contrôle de seuil pour le courant (Id) circulant dans un élément d'entraînement (5).

**12.** Appareil selon l'une des revendications 9 à 11, intégré dans un système de commande du système à porteuses multiples.

**13.** Appareil selon l'une des revendications 9 à 12, dans lequel le rapport d/p entre la distance d entre les surfaces magnétiques du rail (2) et les surfaces magnétiques de la porteuse (1) et le pas p des éléments d'entraînement peut être supérieur à 0,005 ou 0,01 et peut être inférieur à 0,05 ou 0,02 ou 0,011, et/ou le rapport w/p entre la largeur w des noyaux d'électroaimants (24) faisant face à la porteuse (1) et le pas p de l'élément d'entraînement est supérieur à 0,2 ou 0,4.

**14.** Système à porteuses multiples comprenant

un rail (2) le long duquel sont disposés plusieurs éléments d'entraînement électriques (5) pouvant être entraînés individuellement, au moins une porteuse (1) pouvant être entraînée par lesdits éléments d'entraînement (5) le long dudit rail (2), de préférence dans l'une ou l'autre des deux directions du rail,

une structure de commande (22, 23, 21, 7, 8) pour entraîner ladite porteuse (1) le long dudit rail (2),

des moyens de suivi pour suivre la position de la porteuse entraînée (1) dans ledit système à porteuses multiples, et

un appareil de surveillance du système selon l'une des revendications 9 à 13.

15. Système à porteuses multiples selon la revendication 14, dans lequel la structure de commande est structurée hiérarchiquement et comprend

plusieurs contrôleurs de bobines (22, 23), chacun étant connecté à un élément d'entraînement respectif (5) pour lui fournir de la puissance, de préférence de la puissance PWM, et générer des signaux de mesure de courant,

plusieurs contrôleurs de groupes de bobines (6, 21), chacun étant connecté à plusieurs contrôleurs de bobines (22, 23) pour leur fournir des signaux de commande d'alimentation, de préférence des signaux de commande PWM, et pour recevoir d'eux des signaux de mesure de courant,

un ou plusieurs contrôleurs de segments (7), chacun étant connecté à plusieurs contrôleurs de groupes de bobines (21) pour leur envoyer des valeurs de consigne de courant et pour recueillir d'eux des informations de mesure de courant, et

un contrôleur de système (8) connecté à un ou plusieurs contrôleurs de segments (7) pour leur envoyer des valeurs de consigne de vitesse de la porteuse ou des valeurs de consigne de position, pour recueillir d'eux des informations de mesure de courant et pour assurer le suivi de la porteuse.

# Fig. 1a

# Fig. 1b

# Fig. 2a

# Fig. 2b

System controller — 8

"Test"
Id* for all

Results + $ID_7$ + $ID_{21}$ + $ID_{22,23}$

Tracking

Segment controller — 7
"$ID_7$"

"Test", Id* or
duty ratio for all

Results + $ID_{21}$ + $ID_{22,23}$

Tracking

Group controller — 21
"$ID_{21}$"

"Test"
Pulses for all

Results

Tracking

Drive elem. controller 22, 23

# Fig. 3a

# Fig. 3b

# Fig. 3c

# Fig. 4a

# Fig. 4b

# Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10432117 B1
- EP 3196719 B1
- EP 3807605 B1
- EP 3958450 A1
- WO 2012107431 A1